# DEMANDE DE BREVET EUROPEEN

(11) **EP 3 492 892 A1**
(43) Date de publication de la demande: **05.06.2019**
(21) Numéro de dépôt: 18209895.4
(22) Date de dépôt: 03.12.2018
(51) Int. Cl.: G01J 5/04, G01J 5/02, G01J 5/06, G01J 5/34, G01J 5/08, G01J 5/00

(54) **CAPTEUR DE MOTIF THERMIQUE A CAPACITE PYROELECTRIQUE**

(30) Priorité: 04.12.2017 FR 1761599
(71) Demandeur: Commissariat à l'énergie atomique et aux énergies alternatives, 75015 Paris (FR)
(72) Inventeur: BENWADIH, Mohammed, 94500 CHAMPIGNY SUR MARNE (FR)
(74) Mandataire: Brevalex

(57) **Abrégé**

Capteur de motif thermique comportant plusieurs pixels (102) disposés sur un substrat (104), chaque pixel (102) comprenant une capacité pyroélectrique, la capacité pyroélectrique comprenant :
- une couche en matériau pyroélectrique (200) poreux, disposée entre une première électrode électriquement conductrice (108) et une seconde électrode électriquement conductrice (110),
- des particules (210) en un premier matériau remplissant au moins partiellement les pores de la couche en matériau pyroélectrique (200), le premier matériau étant électriquement isolant et ayant des propriétés pyroélectriques, et
- une couche (220) en un second matériau étant disposée entre la couche en matériau pyroélectrique (200) et la seconde électrode (110), le second matériau étant électriquement isolant et ayant des propriétés pyroélectriques.

## Description

### DOMAINE TECHNIQUE ET ART ANTÉRIEUR

L'invention se rapporte à un capteur de motifs thermiques, exploitant les propriétés de pyroélectricité d'un matériau, et formant avantageusement un capteur d'empreinte digitale.

La détection d'empreinte digitale peut être réalisée par des capteurs dits « passifs » exploitant une différence de températures entre celle du doigt et celle du capteur, comme décrit dans les documents US 4 394 773, US 4 429 413 et US 6 289 114. Au niveau des crêtes de l'empreinte, le doigt est en contact physique direct avec le capteur. Un transfert thermique entre la peau et la surface de contact du capteur s'effectue par conduction, ce qui conduit à une première variation temporelle de température. Au niveau des vallées de l'empreinte, le doigt n'est pas en contact physique direct avec le capteur, le transfert thermique s'effectue donc à travers l'air qui est plutôt un isolant thermique, ce qui conduit à une seconde variation temporelle de température, moins importante. La différence entre ces deux variations temporelles de température se traduit par une différence entre des signaux mesurés par les capacités pyroélectriques, selon qu'elles se trouvent sous une vallée ou sous une crête de l'empreinte. L'image de l'empreinte présente donc un contraste qui dépend de cette différence.

Cependant, ces capteurs ont pour inconvénient de réaliser une mesure qui dépend uniquement de la différence entre la température du doigt et la température du capteur. Ainsi, après quelques secondes à peine, la température du doigt et la température de la surface de contact du capteur s'homogénéisent, et il n'est plus possible d'obtenir un contraste satisfaisant.

Il peut également arriver que le niveau du signal obtenu soit nul lorsque le doigt et le capteur sont à la même température, ou encore que le contraste des images capturées varie, ce qui pose alors des problèmes lors du traitement ultérieur des images obtenues (par exemple, une inversion des températures entraîne une inversion de l'image obtenue).

Un autre type de capteur, de type actif, offre une solution à ce problème grâce à l'ajout d'éléments chauffants sous la surface de contact du capteur. Un tel capteur est décrit par exemple dans la demande de brevet EP 2 385 486 A1. Les éléments chauffants dissipent une certaine quantité de chaleur dans chaque pixel du capteur et l'échauffement des pixels est mesuré au bout d'un certain temps. La variation de température obtenue est donc importante au niveau des vallées de l'empreinte, où la chaleur est transférée au doigt à travers l'air, et plus faible au niveau des crêtes de l'empreinte, où la chaleur est transférée directement au doigt, par conduction. Cela conduit à une température finale plus faible dans le cas d'un pixel en présence d'une crête de l'empreinte, où la chaleur est absorbée par la peau, par rapport à un pixel en présence d'une vallée de l'empreinte. Cela permet d'améliorer et de conserver au cours du temps, le contraste d'une image acquise à l'aide dudit capteur.

Les éléments décrits ci-dessus pour la détection d'empreinte digitale s'appliquent également à la détection d'un motif thermique autre qu'une empreinte digitale, l'élément dont le motif thermique à détecter étant disposé sur le capteur lors de la mesure.

Un capteur de motifs thermiques comporte des moyens de détection thermique qui peuvent être des éléments pyroélectriques, des diodes, des thermistances ou tout autre élément sensible à la température permettant de convertir une variation de température en une variation de potentiel ou de courant électrique.

Plus particulièrement, un capteur de type pyroélectrique comporte une matrice de capacités pyroélectriques disposées sur un substrat, par exemple en verre. Chaque capacité pyroélectrique comporte une portion en matériau pyroélectrique, disposée entre une électrode inférieure et une électrode supérieure. Une électrode est portée à un potentiel constant, et forme une électrode de référence. L'autre électrode collecte des charges pyroélectriques, générées par le matériau pyroélectrique en réponse à une variation de température.

Le matériau pyroélectrique peut être par exemple un poly(fluorure de vinylidène-trifluoroéthylène) (noté P(VDF-TrFE)), un polyfluorure de vinylidène (PVDF), une céramique telle que du PZT (titano-zirconate de plomb, ou « Lead Zirconate Titanate » en anglais), de l'AIN, du BaTiO₃ ou encore du ZnO. D'autres matériaux pyroélectriques sont possibles, à savoir tous ceux qui produisent des charges électriques en fonction d'un paramètre pyroélectrique. L'électrode supérieure est recouverte d'une couche de protection sur laquelle l'élément dont le motif thermique est mesuré, par exemple un doigt, est destiné à être disposé lors de la mesure.

Dans le cas d'un capteur thermique actif, le capteur est également muni d'un élément chauffant généralement réalisé à partir de la même couche électriquement conductrice que celle servant à réaliser l'électrode supérieure. Cet élément chauffant est par exemple réalisé sous la forme d'un serpentin entourant partiellement les électrodes supérieures et permettant de chauffer latéralement les capacités pyroélectriques, au niveau des électrodes supérieures.

Chaque capacité pyroélectrique forme un transducteur qui traduit une variation temporelle de température en un signal électrique tel qu'une différence de potentiels électriques.

Lorsque le capteur doit être réalisé avec une surface importante ou avec un faible coût, le capteur est avantageusement réalisé en technologie dite imprimée, ou dépôt par impression, moins onéreuse que la lithographie sur semi-conducteur. Les différentes portions conductrices formant les éléments des pixels du capteur peuvent dans ce cas être réalisées avec des encres conductrices suffisamment stables pour ne pas nécessiter d'encapsulation très performante. La réalisation du capteur est envisageable par impression, par exemple sur des substrats plastiques simples tels que des films de poly(téréphtalate d'éthylène) (PET), de poly(naphtalate d'éthylène) (PEN) ou de polycarbonate (PC).

Dans un tel capteur réalisé par dépôt par impression, le matériau pyroélectrique imprimé présente plusieurs défauts inhérents aux techniques d'impression tels qu'une certaine porosité et des effets de bord générant des courants de fuites importants, entre les électrodes des capacités, pouvant empêcher le bon fonctionnement du capteur. Par exemple, pour des capteurs comprenant des capacités pyroélectriques formées d'empilements du type Au/PVDF/poly(3,4-éthylènedioxythiophène) (aussi appelé PEDOT) ou Au/PVDF/Ag, les courants de fuite sont de l'ordre d'1 µA, ce qui est trop important étant donné que les courants pyroélectriques obtenus sont de l'ordre du nA. Un tel courant de fuite est obtenu en raison des porosités importantes (diamètre de l'ordre de 5 µm) formées dans le PVDF. Ce courant de fuite défavorise fortement l'étape de polarisation du PVDF devant être mise en oeuvre. En effet, la couche de PVDF-TrFe ou de PVDF poreuse peut être fragilisée, voire complètement endommagée (claquage), lors de l'application de la forte tension d'environ 150V/µm nécessaire à la polarisation.

### EXPOSÉ DE L'INVENTION

Un but de la présente invention est de proposer un capteur de motif thermique dont la structure soit compatible avec la réalisation d'un capteur de type passif ou actif, et dont les courants de fuite sont diminués par rapport à l'art antérieur.

Pour cela, la présente invention propose un capteur de motif thermique comportant plusieurs pixels disposés sur un substrat, chaque pixel comprenant une capacité pyroélectrique, la capacité pyroélectrique comprenant une couche en matériau pyroélectrique poreux, disposée entre une première électrode électriquement conductrice et une seconde électrode électriquement conductrice,
des particules en un premier matériau remplissant au moins partiellement les pores de la couche en matériau pyroélectrique poreux,
le premier matériau étant électriquement isolant et ayant des propriétés pyroélectriques.

Une couche en un second matériau est disposée entre la couche en matériau pyroélectrique poreux et la seconde électrode, le second matériau étant électriquement isolant et ayant des propriétés pyroélectriques.

Le premier matériau et le second matériau peuvent être identiques ou différents.

L'invention se distingue fondamentalement de l'art antérieur en ce que des particules électriquement isolantes (typiquement ayant une résistivité électrique supérieure à 10⁹ohm, et de préférence supérieure ou égale à 10¹⁰ohm) et ayant des propriétés pyroélectriques (typiquement ayant un coefficient pyroélectrique supérieur à 5µC/m²K) remplissent au moins partiellement les pores du matériau pyroélectrique poreux, ce qui réduit fortement le courant de fuite et améliore la polarisation générale du dispositif. L'intégration de ces particules dans le matériau pyroélectrique densifie au moins localement la couche en matériau pyroélectrique sans changer ses propriétés pyroélectriques. Le coefficient pyroélectrique de la capacité et le transfert thermique entre les deux électrodes sont améliorés par rapport à une capacité comprenant, par exemple, du PVDF seul sans particules.

De plus, la couche en un second matériau couche forme une couche diélectrique qui améliore la densification de la couche de matériau pyroélectrique sous la seconde électrode, sans modifier ses propriétés pyroélectriques. La couche en un second matériau peut être une couche de particules ou une couche dense non poreuse. Par remplir au moins partiellement les pores, on entend que le volume des pores est au moins partiellement remplis par les particules et/ou qu'au moins une partie du nombre total de pores est remplis par les particules. Les particules peuvent être situées au niveau des ouvertures des pores et/ou pénétrer dans le volume des pores. Les particules peuvent boucher complètement une partie des pores ou la totalité des pores.

Avantageusement, le premier matériau et/ou le second matériau sont en ZnO stoechiométrique, et/ou en un mélange de Zn(OH)₂ et de ZnO, stoechiométrique et/ou non stoechiométrique, et/ou en AIN, et/ou en un mélange de AIN et de Zn(OH)₂ et/ou de ZnO stoechiométrique et/ou non stoechiométrique.

Le ZnO stoechiométrique est isolant électriquement et présente de bonnes propriétés pyroélectriques.

Le ZnO non stoechiométrique est électriquement semi-conducteur et présente de bonnes propriétés pyroélectriques. L'hydroxyde de zinc est électriquement isolant et ne présente pas de propriétés pyroélectriques. Le mélange ZnO/Zn(OH)₂ présente une faible conductivité électrique et de bonnes propriétés pyroélectriques, ce qui permet de limiter les courants de fuite tout en assurant une continuité de propriétés pyroélectriques entre la couche en matériau pyroélectrique et la seconde électrode.

On choisira, de préférence, du ZnO non stoechiométrique qui est moins cher à produire que le ZnO stoechiométrique qui nécessite une étape de traitement thermique dans un réacteur à haute température. De plus, le ZnO stoechiométrique est moins stable sous rayonnement ultra-violet et à tendance à se dégrader en ZnO non stoechiométrique.

Par particules en un mélange de ZnO/Zn(OH)₂, on entend un mélange de particules en ZnO et/ou de particules en Zn(OH)₂ et/ou de particules en un mélange de ZnO/Zn(OH)₂.

Le nitrure d'aluminium AIN est un très bon isolant électrique (de l'ordre de 10¹⁴ ohm.cm , c'est-à-dire une résistance supérieure à 10¹⁰ ohm) et présente de bonnes propriétés pyroélectriques. Ce matériau présente également une très bonne conductivité thermique (de l'ordre de 140-180 W.m⁻¹K⁻¹).

Avantageusement, le premier matériau et/ou le second matériau sont en un mélange de AIN et de ZnO/Zn(OH)₂ comprenant 50% massique de AIN. Un tel matériau est facile à élaborer.

Avantageusement, le matériau pyroélectrique est du polyfluorure de vinylidène, un copolymère de polyfluorure de vinylidène, tel que le poly(fluorure de vinylidène-trifluoroéthylène), une céramique, telle que du PZT, de l'AIN, du BaTiO₃ ou encore du ZnO. L'invention est particulièrement pertinente dans le cas du PVDF qui présente plusieurs défauts inhérents aux techniques d'impression (porosité et effets de bord générant des courants de fuites importants) empêchant le bon fonctionnement des dispositifs.

Avantageusement, le matériau pyroélectrique a une porosité surfacique supérieure à 15% de la surface totale du matériau pyroélectrique.

Avantageusement, la couche en matériau pyroélectrique a une épaisseur allant de 20nm à 5µm, et de préférence, de 2µm à 4µm.

Avantageusement, le capteur comporte en outre au moins un élément chauffant isolé électriquement des électrodes électriquement conductrices et disposé en regard d'au moins une partie de la couche en matériau pyroélectrique tel que la couche en matériau pyroélectrique soit disposée entre l'élément chauffant et le substrat.

Avantageusement, le capteur est un capteur d'empreinte digitale.

L'invention concerne également un procédé de fabrication d'un capteur de motif thermique tel que défini précédemment comprenant les étapes successives suivantes :
a) fourniture d'un substrat, recouvert par une première électrode, et une couche en matériau pyroélectrique poreux,
b) dépôt de particules en un premier matériau de manière à remplir au moins partiellement les pores de la couche en matériau pyroélectrique poreux,
c) dépôt d'une couche en un second matériau sur la couche en matériau pyroélectrique poreux,
d) formation d'une seconde électrode,
e) éventuellement dépôt d'une couche diélectrique et formation d'un élément chauffant,
f) éventuellement, dépôt d'une couche de protection,
le premier matériau étant électriquement isolant et ayant des propriétés pyroélectriques,
le second matériau étant électriquement isolant et ayant des propriétés pyroélectriques.

De préférence le premier matériau et le second matériau sont identiques, ce qui simplifie le procédé d'élaboration, les particules et la couche sur la couche pyroélectrique pouvant être réalisées en une seule et même étape.

Avantageusement, entre l'étape b) et l'étape d), et/ou éventuellement entre l'étape c) et l'étape d), le procédé comporte une étape additionnelle dans laquelle un traitement thermique à une température allant de 120°C à 180°C est réalisé. Le recuit permet d'évaporer complètement les résidus de solvant et/ou de former un matériau pyroélectrique cristallin, ce qui améliore ses propriétés pyroélectriques, notamment dans le cas de particules de ZnO ou de ZnO/Zn(OH)₂. Avantageusement, avec des particules de AIN, la matière est auto-organisée en sortie du dépôt et il n'y a pas besoin de réaliser d'étapes de recuit et/ou de polarisation.

Avantageusement, l'étape b) est réalisée en déposant une solution contenant des particules de ZnO, stoechiométrique, et/ou en un mélange de Zn(OH)₂ et de ZnO, stoechiométrique ou non stoechiométrique, et un solvant, de préférence choisi parmi l'acétate de butyle, l'acétate de propyle, l'isopropanol, l'éthanol, le méthanol, le méthoxyéthanol, l'éthoxyéthanol, l'hexane, et le cyclohexane.

Avantageusement, la solution contenant les particules est déposée par dépôt à la tournette ou par sérigraphie. Un dépôt par sérigraphie permet de déposer localement les particules.

Avantageusement, la solution contient de 5mg/mL à 100mg/mL, et de préférence de 10mg/mL à 50mg/mL de particules.

Avantageusement, les particules sont obtenues en réalisant les étapes successives suivantes :
- préparation et mélange d'une solution comprenant de l'acétate de zinc, du KOH, et un solvant dans lequel le ZnO et/ou le ZnO/Zn(OH)₂ sont insolubles,
- chauffage de la solution à la température d'ébullition du solvant, sous reflux, l'acétate de zinc et le KOH réagissant pour former du ZnO et/ou du ZnO/Zn(OH)₂,
- décantation de la solution obtenue à l'étape précédente,
- de préférence, ajout d'un surfactant pour disperser les particules.

Avantageusement, la couche en matériau pyroélectrique poreux est déposée par une technique d'impression telle que la sérigraphie.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
- la figure 1 représente, de manière schématique, une vue en coupe d'un pixel d'un capteur de motif thermique, selon un premier mode de réalisation particulier de l'invention,
- la figure 2 représente de manière schématique, une vue en coupe d'un pixel d'un capteur de motif thermique, selon un deuxième mode de réalisation particulier de l'invention,
- la figure 3 est un graphique représentant la capacitance et la conductance en fonction de la fréquence, d'un matériau pyroélectrique recouvert par une couche de ZnO/Zn(OH)₂,
- la figure 4 est un graphique représentant le cycle d'hystérésis de la capacité, pour un matériau pyroélectrique seul et pour un matériau pyroélectrique recouvert par des couches de ZnO/Zn(OH)₂ de différentes épaisseurs,
- la figure 5 est un graphique représentant les épaisseurs de couches de ZnO/Zn(OH)₂ obtenues en déposant une solution contenant des particules de ZnO/Zn(OH)₂, par dépôt à la tournette, en fonction de la concentration massique en particules et de la vitesse de dépôt,
- la figure 6 représente plusieurs clichés de diffraction des rayons X d'une couche de ZnO/Zn(OH)₂ avant et après recuit à 150°C, pendant 15 minutes,
- les figures 7A à 7C représentent des clichés, obtenus par microscopie électronique à balayage, d'une couche de ZnO/Zn(OH)₂ avant (figures 7A et 7B) et après (figure 7C) recuit à 150°C, pendant 15 minutes.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

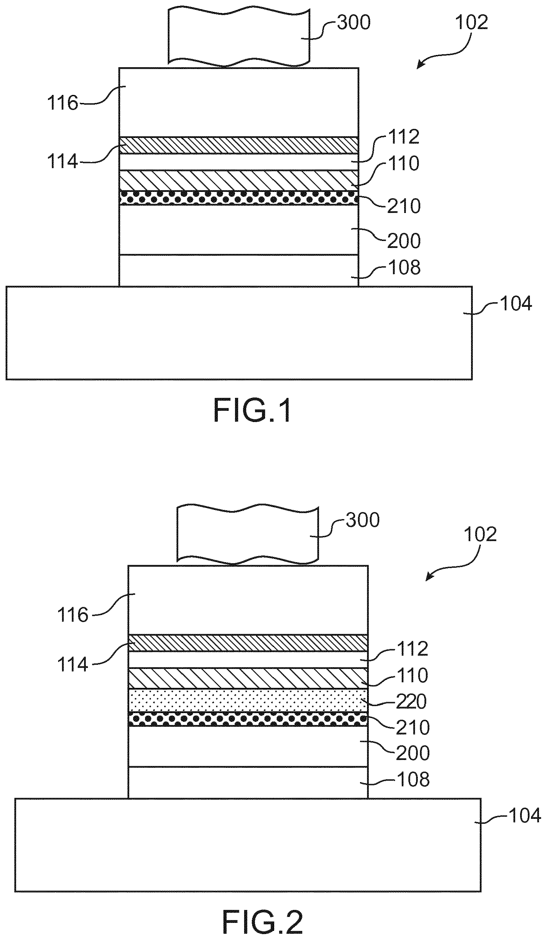

On se réfère tout d'abord aux figures 1 et 2 qui représentent des vues en coupe d'une partie d'un pixel 102 d'un capteur de motif thermique, selon différents modes de réalisation.

### Le substrat 104 :

Le pixel 102 est réalisé sur un substrat 104 par exemple en verre ou en matériau semi-conducteur (par exemple du silicium).

Le substrat 104 peut également être un substrat souple, par exemple à base de polyimide, de PEN (polyéthylène naphtalate), de PET (polyéthylène téréphtalate), ou de polycarbonate (PC), sur lequel les éléments électroniques du capteur, tels que des transistors en couches minces (TFT pour «Thin Film Transistor »), sont réalisés par technologie électronique imprimée (par exemples via une réalisation avec des têtes d'écriture de type jet d'encre, sérigraphie, offset et héliogravure) ou par lithographie.

### Les pixels 102 :

Un seul pixel est représenté sur le substrat 104 représenté à la figure 1, pour plus de lisibilité, mais le substrat d'un capteur de motif thermique comporte une pluralité de pixel 102. Les pixels 102 du capteur sont disposés en formant une matrice de plusieurs lignes et plusieurs colonnes de pixels 102. Le pas des pixels 102, dans le plan du substrat 104, est par exemple compris entre environ 50 µm et 100 µm. Dans le cas d'un capteur de résolution égale à 500 dpi (« dot per inch »), le pas des pixels 102 est égal à 50,8 µm.

Chacun des pixels 102 du capteur comporte des moyens de mesure, ou de détection, thermique formés par une capacité pyroélectrique. Chaque capacité pyroélectrique comporte successivement, depuis le substrat 104, une électrode inférieure 108, un matériau pyroélectrique 200 et une électrode supérieure 110. La capacité est décrite ici et par la suite comme étant une capacité verticale, mais il pourrait également s'agir d'une capacité horizontale.

### Le matériau pyroélectrique 200 :

La couche en matériau pyroélectrique 200 est une couche poreuse. La couche comprend une première face principale en contact avec la première électrode. Par en contact, on entend que ces éléments sont adjacents. La seconde face principale est en regard de la seconde électrode.

Le matériau pyroélectrique est, par exemple, du polyfluorure de vinylidène ou un copolymère de polyfluorure de vinylidène, tel que le copolymère polyfluorure de vinylidène et de trifluoroéthylène P(VDF-Trfe). Différentes compositions en TrFe dans le P(VDF-TrFe) sont envisageables, afin d'obtenir des fortes valeurs de coefficient pyroélectrique. Ces compositions peuvent correspondre à un pourcentage en mole allant de 10 % à 50 % pour le TrFe et allant de 90 % à 50 % pour le PVDF. Préférentiellement, le pourcentage en mole est d'environ 20 % pour le TrFe et d'environ 80 % pour le PVDF, ce qui permet d'obtenir de meilleures caractéristiques en cristallisation du matériau pyroélectrique. Le PVDF présente, par exemple, une permittivité diélectrique de l'ordre de 10.

L'homme du métier pourra choisir tout matériau pyroélectrique poreux qui produit des charges électriques en fonction d'un paramètre pyroélectrique.

L'épaisseur de la couche en matériau pyroélectrique 200 va par exemple de 20 nm à 5 µm, et de préférence de 1µm à 5µm. Elle est, par exemple, de 2µm. De préférence, elle va de 100 nm à 3 µm, plus préférentiellement de 100 nm à 2 µm et par exemple égal à environ 1 µm. L'épaisseur de matériau pyroélectrique 200 déposée est contrôlée car cette épaisseur correspond à l'épaisseur de la capacité pyroélectrique (distance entre les électrodes) et intervient directement dans le calcul de la valeur de la capacité pyroélectrique C.

La taille des pores du matériau pyroélectrique, va par exemple de 1µm à 10µm, et de préférence de 2µm à 10µm. On choisira par exemple des tailles de pores de l'ordre de 5µm.

Afin de limiter les courants de fuite, les pores de la couche en matériau pyroélectrique sont au moins partiellement remplis par des particules 210 en un premier matériau électriquement isolant et ayant des propriétés. Les particules 210 peuvent être localisées au niveau des ouvertures des pores, situées sur la seconde face de la couche en matériau pyroélectrique poreux. Elles peuvent partiellement ou complètement boucher les ouvertures des pores. Elles peuvent également être localisées dans le volume des pores. Elles peuvent être localisées, par exemple, dans le premier tiers ou dans la première moitié de l'épaisseur de la couche en matériau pyroélectrique poreux à partir de la seconde principale de ladite couche. La seconde face principale peut être en contact avec la seconde électrode.

Par particules, on entend des éléments de taille nanométrique, ou micrométrique et de forme sphérique, cylindrique, ou ovoïde.

Les particules ont, par exemple, une plus grande dimension allant de 20nm à 1µm, et de préférence de 20nm à 100nm.

Les particules 210 peuvent être, partiellement ou totalement, recouverte par une couche de résidus organiques provenant de la synthèse desdites particules.

De préférence, une couche 220 en un second matériau, identique ou différent du premier matériau, recouvre, en plus, la couche de matériau pyroélectrique. La couche 220 en un second matériau est en contact avec la seconde électrode.

La couche 220 peut être une couche de particules, en contact les unes avec les autres, ou une couche dense, pleine (non particulaire).

La couche 220 a une épaisseur allant de 10nm à 500nm, par exemple de 10nm à 300nm, et de préférence de 50nm à 500nm.

De préférence, le premier matériau et/ou le second matériau sont en ZnO stoechiométrique et/ou en un mélange de Zn(OH)₂ et de ZnO, stoechiométrique ou non stoechiométrique, et/ou en AIN, et/ou en un mélange de AIN et de Zn(OH)₂ et/ou de ZnO stoechiométrique et/ou non stoechiométrique.

La résistance de tels matériaux est supérieure à 10⁹ ohm.cm, de préférence supérieure à 10¹⁰ohm.cm, encore plus préférentiellement supérieure à 10¹⁴ ohm.cm. Ceci permet d'éviter les courants fuites entre les deux électrodes.

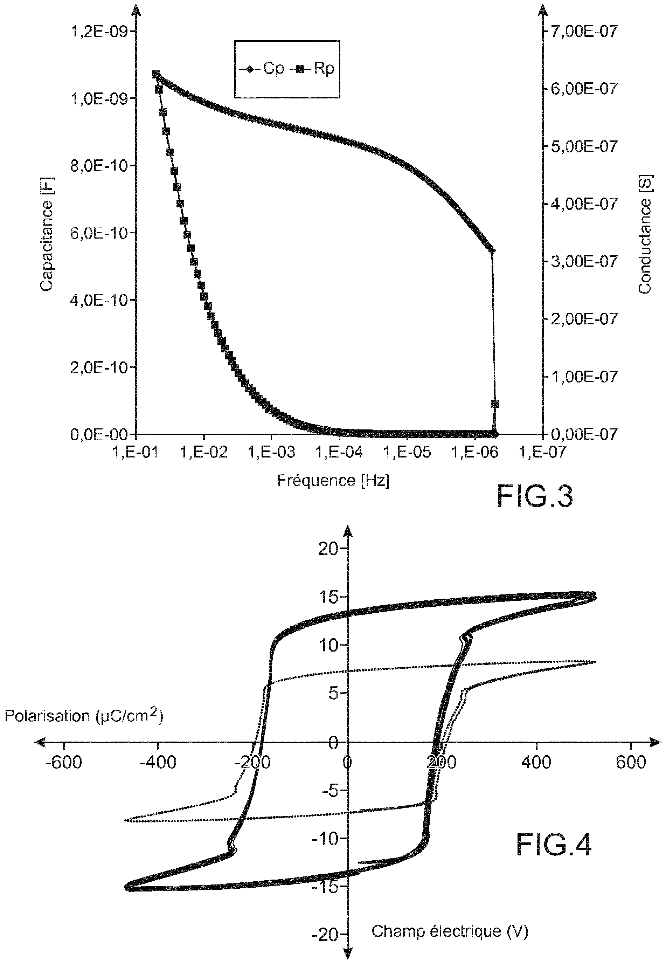

Comme représenté sur la figure 3, la présence d'une couche 220 en ZnO/Zn(OH)₂ de 100nm d'épaisseur sur une couche pyroélectrique en PVDF dont les pores sont partiellement remplis par des particules 210 en ZnO/Zn(OH)₂ ne modifie pas la capacité. On mesure une valeur d'environ 1nF pour une surface de 30mm².

Les caractéristiques électriques de couches pyroélectriques avec et sans couche/particules de ZnO/Zn(OH)₂ ont été comparées (figure 4). Après avoir polarisé le PVDF, on remarque que les propriétés pyroélectriques sont améliorées grâce à la présence de la couche et des particules de ZnO/Zn(OH)₂. Le cycle hystérésis ne change pas quelle que soit l'épaisseur de la couche en ZnO/Zn(OH)₂ (de 100 à 500nm).

### Les électrodes 108, 110 :

L'électrode inférieure (ou première électrode) 108 et l'électrode supérieure (ou seconde électrode) 110 comportent chacune au moins un matériau électriquement conducteur. Les électrodes 108, 110 peuvent comporter au moins l'un des matériaux suivants : Ti, Pt, Ni, Au, Al, Mo, Ag, MoCr, AISi, AlCu. L'une des électrodes 108, 110, avantageusement l'électrode supérieure 110, ou chacune des deux électrodes 108, 110, peut être formée par un empilement de plusieurs matériaux électriquement conducteurs, par exemple un empilement Ti/TiN, Ti/TiN/AICu, ou Ti/Au.

L'épaisseur de chacune des électrodes 108, 110 est par exemple comprise entre environ 0,01 µm et 1 µm. L'épaisseur de chacune des électrodes 108, 110 peut être plus importante, allant par exemple jusqu'à environ 5 µm, notamment lorsque ces électrodes sont réalisées par impression en utilisant des matériaux tels que l'argent, le cuivre, le carbone ou encore le PEDOT(poly(3,4-éthylènedioxythiophène). Une couche d'or déposée par photolithographie a, par exemple, une épaisseur de 50nm.

A titre illustratif et non limitatif, l'électrode supérieure 110 et/ou l'électrode inférieure 108 est une couche d'épaisseur égale à environ 0,2 µm, en titane et/ou en molybdène et/ou en aluminium et/ou en un oxyde conducteur tel que de l'ITO (oxyde d'indium et d'étain) et/ou un polymère conducteur.

A titre illustratif et non limitatif, l'électrode supérieure 110 et/ou l'électrode inférieure 108 est formée d'un ou plusieurs empilements de type Ti/TiN avec une épaisseur de Ti comprise entre environ 50 nm et 500 nm et une épaisseur de TiN comprise entre environ 10 nm et 500 nm. On pourra également utiliser un empilement Ti/Au avec une épaisseur de Ti de 5nm et une épaisseur de Au de 50 nm, ou une couche d'or de 50nm d'épaisseur, ou encore un alliage MoCr de 50 nm d'épaisseur. On pourra combiner, par exemple, une électrode inférieure en Ti/Au, par exemple déposée par photolithographie, et une électrode supérieure en PEDOT-PSS de 1µm d'épaisseur.

L'électrode supérieure 110 et/ou l'électrode inférieure 108 est, par exemple, sous la forme de lignes métalliques parallèles les unes aux autres. De telles lignes sont, par exemple, en or. L'électrode inférieure 108 peut également être en or, et l'électrode supérieure 110 peut être en PEDOT-PPS et peut avoir, par exemple, une épaisseur de 1µm.

### La couche diélectrique 112 :

L'électrode supérieure 110 est recouverte par une couche diélectrique 112. L'épaisseur de la couche diélectrique va par exemple de 0,1µm à 5 µm. La couche diélectrique est, par exemple, en polyimide. Elle permet d'isoler électriquement l'électrode supérieure 110 des éléments chauffants 114.

### Les éléments chauffants 114 :

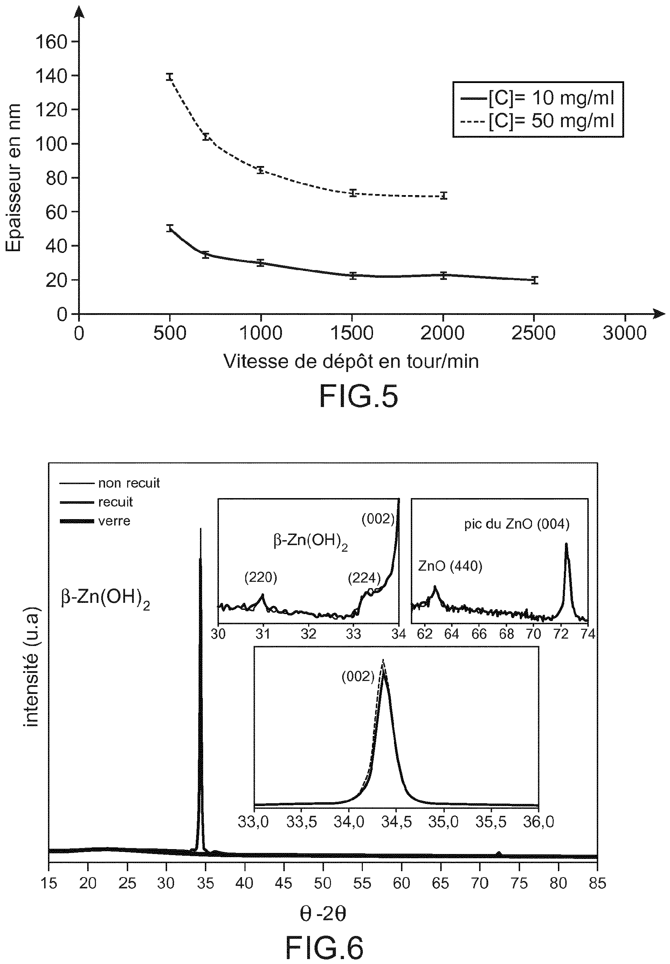

Dans le mode de réalisation où le capteur est apte à réaliser une détection thermique active, en plus des éléments précédemment décrits, le capteur comporte également des éléments chauffants 108 dissipant une certaine quantité de chaleur dans les pixels 102, et notamment dans le matériau pyroélectrique 200. Ces éléments chauffants 108 sont par exemple formés par des portions électriquement conductrices issues de la même couche que celle servant à la réalisation des électrodes supérieures 110 ou des électrodes inférieures 108. Le ou les matériaux servant à la réalisation de l'élément chauffant 114 peuvent être choisis parmi mes matériaux suivants : Ti, Pt, Ni, Au, Al, Ag, AISi, AlCu. Les éléments chauffants 114 sont par exemple réalisés par un dépôt d'une encre métallique, comprenant par exemple de l'argent, déposée par impression. Les éléments chauffants 114 sont, par exemple, sous la forme de lignes métalliques parallèles les unes aux autres. Comme représenté sur la figure 5, les lignes formant les éléments chauffants peuvent être perpendiculaires aux lignes de l'électrode inférieure 108.

L'élément chauffant 114 peut comprendre une couche en Ti ayant une épaisseur allant d'environ 30 nm à 100 nm et une autre couche électriquement conductrice en AISi ou en AlCu et ayant une épaisseur allant de 100 nm à 700 nm. Dans une telle configuration, la couche d'AISi ou d'AICu protège la couche de titane ou de TiAu contre l'oxydation.

Les éléments chauffants 114 ont, par exemple, une épaisseur allant de 0,5µm à 10µm, et de préférence allant de 1µm à 5µm.

Chacun des éléments chauffants 114 forme un élément métallique résistif (résistance électrique par exemple comprise entre environ 10 Ω et 100 Ω) associé à un pixel 102 et qui permet de chauffer ce pixel 102 indépendamment des éléments chauffants 114 associés aux autres pixels 102. Les éléments chauffants 114 permettent, lors d'une détection mise en oeuvre par le dispositif, de dissiper une certaine quantité de chaleur dans les pixels 102, et notamment dans le matériau pyroélectrique de la couche 113. Dans chaque pixel 102, le chauffage de la portion 200 de matériau pyroélectrique est obtenu en faisant circuler un courant dans l'élément chauffant 114 formant la résistance de chauffage de chacun des pixels 102.

Le chauffage du matériau pyroélectrique 200 est obtenu en faisant circuler un courant dans l'élément chauffant 114 formant la résistance de chauffage de chacun des pixels 102. Afin d'obtenir une bonne sensibilité à la détection, traduisant une forte différence de températures entre un pixel en contact avec une crête de l'empreinte et un pixel en contact avec une vallée de l'empreinte, les puissances électriques injectées dans l'élément chauffant peuvent aller de 0,5 mW/pixel à 5 mW/pixel dans le cas de pixels ayant des côtés de dimension égale à environ 50 µm (comme c'est le cas pour un capteur d'empreinte digitale standard de résolution égale à 500 dpi).

### La couche de protection 116 :

Les éléments chauffants 114 ainsi que les parties de la couche diélectrique 112 sur lesquelles les éléments chauffants 114 ne sont pas présents sont, avantageusement, recouverts par une couche de protection 116, correspondant par exemple à une couche laminée de PET ou de tout autre matériau adapté à la réalisation de cette couche. D'autres matériaux sont aussi envisageables pour cette couche 116, comme par exemple du polyimide, du PVDF et/ou de ses copolymères, du PMMA, etc. Le ou les matériaux utilisés ainsi que l'épaisseur de la couche sont choisis pour obtenir un bon transfert de la chaleur depuis la face avant 116 vers la capacité pyroélectrique. Ainsi, la couche de protection 116 est réalisée telle qu'elle ne soit ni trop thermiquement résistive (car la chaleur ne la traverserait pas), ni trop thermiquement conductrice (car la chaleur partirait dans ce cas sur les côtés, vers les autres pixels, provoquant de la diathermie au sein du capteur), ni trop épaisse (pour avoir un transfert de chaleur s'opérant depuis la face avant de la couche de protection 116 vers la capacité pyroélectrique), ni trop fine (l'épaisseur de la couche 116 doit tout de même être suffisante pour que son rôle de protection soit rempli). L'épaisseur de la couche de protection 116 peut aller de quelques microns (par exemple 5 µm) à environ 100 µm. L'épaisseur est par exemple de l'ordre de 10µm. De manière alternative, la couche de protection 116 peut correspondre à une couche de DLC (« Diamond Like Carbon ») d'épaisseur inférieure à environ 1 µm.

La face supérieure de la couche de protection 116 correspond à la surface sur laquelle se trouve le motif thermique destiné à être détecté, par exemple un doigt dont l'empreinte est destinée à être détectée. La partie d'un doigt 300 avec les creux et les bosses de l'empreinte sont représentées sur la figure 1.

### Procédé de fabrication et de dépôt des particules en ZnO ou en ZnO/Zn(OH)₂

La synthèse des particules 210 est obtenue en réalisant les étapes successives suivantes :
i. préparation d'une première solution comprenant de l'acétate de zinc et un premier solvant dans lequel le ZnO et/ou le ZnO/Zn(OH)₂ sont insolubles et chauffage de la solution à la température d'ébullition du premier solvant, sous reflux,
ii. préparation d'une seconde solution contenant du KOH dans un second solvant, miscible avec le premier solvant et dans lequel le ZnO et/ou le ZnO/Zn(OH)₂ sont insolubles, et chauffage de la solution à la température d'ébullition du second solvant, sous reflux,
iii. mélange de la première solution avec la seconde solution, l'acétate de zinc et le KOH réagissant pour former du ZnO et/ou du ZnO/Zn(OH)₂ insoluble dans le méthanol, et maintien du chauffage à la température d'ébullition du solvant ayant la température d'ébullition la plus élevée, pendant plusieurs heures sous reflux,
iv. décantation de la solution obtenue à l'étape précédente,
v. ajout d'un surfactant.

De préférence, le premier solvant et le second solvant sont compatibles avec la couche pyroélectrique, notamment dans le cas d'une couche pyroélectrique en PVDF ou en copolymère de PVDF. On choisira le premier solvant et le solvant, indépendamment l'un de l'autre, parmi l'acétate de butyle, l'acétate de propyle, l'isopropanol, l'éthanol, le méthanol, le méthoxyéthanol, l'éthoxyéthanol, l'hexane, et le cyclohexane.

De préférence, le premier et le second solvant sont identiques. Encore plus préférentiellement, il s'agit du méthanol.

L'étape iii peut être réalisée pendant de 1h à 10h, par exemple 3h.

La décantation de l'étape iv peut être réalisée pendant plusieurs heures, par exemple pendant une durée allant de 2h à 10h, par exemple 4h.

Entre l'étape iv et l'étape v, le surnageant peut être enlevé et remplacé un volume identique ou différent du solvant ou du mélange de solvant. On peut, par exemple, rajouter 50mL de solvant ou de mélange de solvant.

Le surfactant a pour rôle de disperser les particules 210 afin de rendre la solution homogène et transparente. Une solution homogène facilitera l'obtention un dépôt homogène. On peut rajouter de 1% à 10% molaire, par exemple, 5% molaire, de surfactant à la quantité de particules 210.

Le surfactant est, de préférence, choisi parmi l'acide méthoxy éthoxy acétique (MEA), l'acide méthoxybenzoïque, l'acide (éthylthio)benzoïque, l'acide diméthoxybenzoïque, l'acide décanoïque, l'acide nitrobenzoïque, l'acide trifluorométhylbenzoïque, ou un de leurs mélanges.

A titre illustratif et non limitatif, les particules de ZnO et/ou de ZnO/Zn(OH)₂ 210 sont obtenues en :
- mélangeant 1,5 grammes d'acétate de Zinc et environ 60ml de méthanol dans un ballon bicol,
- mélangeant, un ballon monocol environ 0,75 grammes d'hydroxyde de potassium et 30ml de méthanol.
- chauffant les deux ballons une dizaine de minutes à 60°C (température d'ébullition du méthanol),
- mélangeant le contenu du premier ballon avec le contenu du second ballon, pendant 3h sous reflux,
- laissant décanter la solution obtenue à l'étape précédente pendant 4h,
- retirant le surnageant, le remplaçant par 50mL de méthanol, puis en laissant décanter une nuit,
- ajoutant 5% molaire d'acide méthoxy éthoxy acétique par rapport à la quantité molaire de particules.

La solution est ensuite déposée par toute technique d'impression adaptée mettant en jeu des encres liquides (sérigraphie, héliogravure, jet d'encre, flexogravure, offset gravure) ou d'enduction. Par exemple, la solution est déposée par dépôt à la tournette (ou « spin-coating »).

La figure 5 représente l'épaisseur de la couche 220 en particules en fonction de la concentration massique en particules dans la solution et en fonction de la vitesse de dépôt. Par exemple, pour avoir une épaisseur de 35nm, on utilisera une vitesse de dépôt d'environ 1000 tour/min et une concentration en particules de 10mg/mL.

Avantageusement, un traitement thermique est réalisée après dépôt des particules. Le recuit est réalisé in situ sur les couches sous-jacentes du capteur de motifs thermiques.

Le traitement thermique est réalisé à une température, de préférence, allant de 120°C à 180°C, par exemple à une température de 150°C. De telles températures pourront, avantageusement, être utilisées pour des recuits sur des substrats en plastique.

L'étape de recuit permet d'éliminer partiellement ou totalement les composés organiques provenant de la synthèse (par exemple les additifs et/ou le solvant), qui peuvent influencer les propriétés pyroélectriques et/ou la permittivité de la couche. Lorsque les composés organiques ne sont pas totalement éliminés, les particules sont recouvertes localement ou partiellement par une couche de résidus organiques.

L'étape de recuit permet également de former du ZnO cristallin. Le matériau après recuit contient du ZnO cristallin, et de l'hydroxyde Zn(OH)₂ (figure 6).

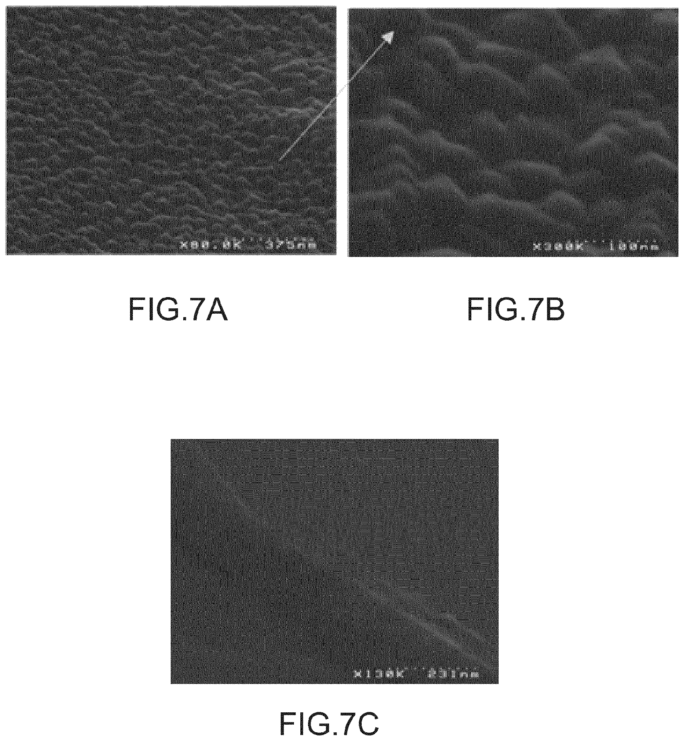

Comme représenté sur les figures 7A et 7B, on remarque un arrangement compact des particules de ZnO avant l'étape de recuit. Après un traitement thermique à 150°C pendant 15 minutes, on observe une diminution de la rugosité et de la taille des grains de la couche de ZnO. La couche de ZnO 220 est densifiée. Après recuit, on obtient une couche de ZnO 220 ayant une conductivité thermique du ZnO = 6W.m⁻¹K⁻¹ et un coefficient pyroélectrique de 20-30 µC/m²K (pour comparaison, le coefficient pyroélectrique du PVDF est de 25 µC/m²K). La conductivité thermique est sensiblement identique (ici du même ordre de grandeur) après densification. La densification peut être, par exemple, quantifiée par rayon X par mesure de réflectivité.

Le recuit peut être réalisé pendant une durée allant de quelques minutes (par exemple 5 minutes) à quelques heures (par exemple 2 heures). On peut, par exemple, réaliser un recuit à 150°C pendant 15 minutes.

Le recuit peut être réalisé dans un four.

Il peut également être réalisé par absorption de lumière intense (laser, xénon flash, infrarouge ou photonique), ce qui améliore la démixtion des différents oxydes.

### Procédé de fabrication du capteur de motif thermique :

Un procédé de fabrication d'un capteur de motif thermique comprenant de telles capacités pyroélectriques va maintenant être décrit.

Le capteur est réalisé à partir du substrat 104. Le matériau du substrat 104 (verre, semi-conducteur, plastique, etc.) est choisi selon la technologie avec laquelle les différents éléments électroniques du capteur sont réalisés. Le substrat 104 est tout d'abord nettoyé afin d'éliminer les résidus organiques présents sur celui-ci. Le type de nettoyage mis en oeuvre sera fonction du matériau du substrat 104.

La deuxième étape consiste à déposer sur la face avant du substrat 104 une première couche électriquement conductrice, par exemple métallique, à partir de laquelle l'électrode 108 est destinée à être réalisée. La couche peut être déposée en phase vapeur PVD par évaporation (« sputtering » en anglais), sérigraphie, pulvérisation (« spray » en anglais) ou même par jet d'encre, selon les matériaux et les épaisseurs destinés à être déposés. Lorsque la couche est formée par un dépôt PVD, l'épaisseur de la couche va, par exemple d'environ 100 nm à 2 µm. De manière générale, l'épaisseur de la couche est supérieure ou égale à environ 100 nm. D'autres types de dépôt peuvent permettre la réalisation d'une couche d'épaisseur supérieure à environ 2 µm. La structure des électrodes 108 peut être définie en mettant en oeuvre une étape de photolithographie et de gravure de la couche.

La couche en matériau pyroélectrique 200 est ensuite formé sur la première électrode 108. Le matériau pyroélectrique en PVDF ou en l'un de ses copolymères peut être déposé par « spin coating » (dépôt à la tournette). D'autres types de dépôts localisés peuvent être utilisés comme la sérigraphie ou la pulvérisation ou même le dépôt par jet d'encre.

Une étape d'irradiation du matériau pyroélectrique peut ensuite être mise en oeuvre pour cristalliser au moins la seconde face de la couche en matériau pyroélectrique, pour améliorer les performances pyroélectriques. Cette irradiation est par exemple mise en oeuvre avec une lumière flash UV, avec une durée du flash, ou de l'impulsion, comprise entre environ 500 µs à 2 ms, une fluence (énergie délivrée par unité d'aire) comprise entre environ 15 J/cm² et 25 J/cm², et avec une lumière de longueur d'onde comprise entre environ 200 nm et 380 nm. Le nombre de flashs, ou impulsions, de lumière UV réalisés lors de cette irradiation varie en fonction de l'épaisseur sur laquelle le matériau pyroélectrique doit être cristallisé. Par exemple, pour une épaisseur de P(VDF-TrFe) égale à environ 2 µm, l'irradiation peut être mise en oeuvre avec une fluence égale à environ 17 J/cm², une durée d'impulsion égale à environ 2 ms et un nombre d'impulsions égal à 5.

Le matériau pyroélectrique ayant éventuellement subi une précédente cristallisation est ensuite soumis à un recuit, par exemple réalisé à environ 130°C pendant environ 60 min, pour finaliser la cristallisation totale du matériau pyroélectrique.

La cristallisation du matériau pyroélectrique peut donc être réalisée en deux temps : tout d'abord l'irradiation par impulsion lumineuse UV pour bien cristalliser la seconde face de la couche en matériau pyroélectrique afin d'augmenter sa conductivité thermique, puis un recuit thermique achevant la cristallisation pour le reste de matériau pyroélectrique non cristallisé par la précédente irradiation.

Lorsque le matériau pyroélectrique est un copolymère à base de P(VDF-TrFe), il est nécessaire de mettre en oeuvre, avant la première utilisation du capteur pour détecter un motif thermique, une étape de polarisation initiale du matériau pyroélectrique en appliquant une tension électrique continue à ses bornes, via les électrodes 108, 110, afin d'améliorer le coefficient pyroélectrique de ce matériau. Cette polarisation est réalisée une seule fois pour toute la durée de vie du matériau pyroélectrique. Cette polarisation par courant continue peut se faire à une température ambiante ou à chaud (jusqu'à environ 100°C). Lorsque la polarisation est réalisée à une température ambiante, il est possible d'appliquer une tension continue jusqu'à environ 150V/µm d'épaisseur de la couche pyroélectrique pendant une durée par exemple comprise entre quelques secondes et quelques minutes. Par exemple, on appliquera une tension de 120V/µm pendant 20s. Lorsque la polarisation est réalisée à chaud, par exemple à une température d'environ 90°C, une tension continue par exemple comprise entre environ 50 V et 80 V par micron d'épaisseur de la couche pyroélectrique peut être appliquée pendant une durée par exemple comprise entre environ 1 min et 5 min. La température est ensuite abaissée jusqu'à atteindre la température ambiante, puis le champ électrique appliqué sur le matériau pyroélectrique, via la tension continue appliquée, est stoppé. De telles polarisations permettent au PVDF d'atteindre des coefficients pyroélectriques compris entre environ 20 et 45 µC/(m².K).

Les molécules à l'intérieur de la couche pyroélectrique 200 restent orientées ainsi, même lorsque le matériau n'est plus soumis à ce champ électrique. Le matériau peut être ainsi polarisé en appliquant une tension de polarisation initiale aux bornes des électrodes 108, 110. On choisira, de préférence, une épaisseur de matériau pyroélectrique inférieure ou égale à environ 2 µm afin de favoriser la polarisation du matériau pyroélectrique de cette capacité, et le niveau de la tension électrique appliquée entre les électrodes 108, 110 pour réaliser la polarisation initiale du matériau pyroélectrique (lorsque le matériau pyroélectrique doit être initialement polarisé).

Les particules 210 de ZnO et/ou de ZnO/Zn(OH)₂ sont ensuite déposées sur la couche en matériau pyroélectrique 200, de manière au moins à remplir partiellement ou totalement les pores de la seconde face principale de ladite couche pyroélectrique 200, et éventuellement, pour former en plus une couche en ZnO 220 sur ladite couche pyroélectrique 200.

Comme précédemment décrit, les particules de ZnO et/ou de ZnO/Zn(OH)₂ 210 peuvent être déposées par toute technique d'impression mettant en jeu des encres liquides (sérigraphie, héliogravure, jet d'encre, flexogravure, offset gravure).

Lorsque la couche en matériau pyroélectrique 200 est recouverte par une couche pleine en ZnO 220, cette couche peut être déposée par une technologie sous vide, telle que la déposition de couche atomique (ALD pour « Atomic Layer Deposition »), par dépôt physique en phase vapeur (PVD pour (« Physical Vapor Deposition ») ou par pulvérisation phase cathodique.

Des portions du matériau pyroélectrique 200 sont définies par la mise en oeuvre d'une photolithographie et d'une gravure du matériau pyroélectrique. Lorsque la gravure mise en oeuvre correspond à une gravure plasma, un plasma O₂ peut être utilisé seul ou en combinaison avec du SF₆ (hexafluorure de soufre). Les portions de matériau pyroélectrique conservées après la mise en oeuvre de cette gravure correspondent aux portions du matériau pyroélectrique localisées au niveau des pixels 102 du capteur.

En variante, les portions peuvent être réalisées directement, sans étape de gravure, par un dépôt localisé correspondant par exemple à un dépôt par spray à ultrasons, ou par jet d'encre ou par sérigraphie.

La seconde électrode, ou électrode supérieure, 110 est ensuite déposée, selon des techniques de dépôt qui peuvent être identiques ou différentes de celles utilisées pour déposer la première électrode.

Une ou plusieurs deuxièmes couches électriquement conductrices destinées à former les éléments chauffants 118 sont ensuite déposées sur la structure obtenue à ce stade du procédé. L'élément chauffant 118 est ensuite formé en gravant la ou les couches électriquement conductrices précédemment déposées selon le motif de l'élément chauffant 118, par exemple sous forme d'un serpentin ou sous la forme d'une ligne rectangulaire. Une étape de photolithographie suivie d'une étape gravure plasma ou en humide sont par exemple mises en oeuvre pour la formation de l'élément chauffant 118. La couche est gravée, par exemple via la mise en oeuvre d'une gravure plasma.

Le ou les matériaux destinés à former la couche de protection 116 est ou sont ensuite déposés sur l'ensemble de la structure précédemment réalisée. Selon le ou les matériaux déposés, le ou les dépôts peuvent se faire par voie physique (par exemple PVD) à faible température ou par voie liquide (par exemple par centrifugation, pulvérisation ou jet d'encre). Lorsque ce ou ces matériaux de protection sont déposés de manière localisée, comme par exemple par pulvérisation ou par jet d'encre, la couche de protection 116 est formée dès le dépôt de manière localisée sur l'élément chauffant 118 et les éventuelles parties de matériau pyroélectrique non recouvertes par l'élément chauffant 118 (comme c'est le cas lorsque l'élément chauffant 118 forme un serpentin localisé uniquement au-dessus des portions 200), et il n'est pas nécessaire de mettre en oeuvre une gravure du ou des matériaux déposés pour former la couche 116.

Dans le cas contraire, le ou les matériaux sont déposés également à côté des portions de matériau pyroélectrique, une gravure, par exemple par plasma, est ensuite mise en oeuvre afin de supprimer les parties du ou des matériaux déposés à côté des portions, permettant ainsi l'accès aux extrémités.

Dans les différents exemples décrits précédemment, le capteur est utilisé en tant que détecteur d'empreinte digitale. Toutefois, le capteur peut être utilisé pour réaliser une détection de motifs thermiques autres que des empreintes digitales, du fait que chaque pixel 102 du capteur lit la capacité calorifique placée au-dessus de lui et cela quelle que soit la nature du motif thermique.

Par exemple, le capteur peut également servir à la réalisation d'un imageur infrarouge non refroidi. Les pixels 102 du capteur sont dans ce cas intégrés sur un circuit intégré de type CCD ou CMOS collectant les charges électriques générées par le capteur. Un tel imageur comporte en outre une lentille infrarouge filtrant la lumière arrivant sur le capteur. Afin que le capteur puisse être soumis à une différence de températures (nécessaire compte tenu de la mesure réalisée par les capacités pyroélectriques), l'imageur comporte un dispositif permettant successivement de bloquer la lumière infrarouge arrivant sur le capteur puis de laisser passer cette lumière. Un tel dispositif peut correspondre à un « chopper », c'est-à-dire une roue munie d'un trou et tournant devant le capteur. Un élément absorbeur peut être ajouté sur le matériau pyroélectrique afin d'améliorer l'absorption du rayonnement infrarouge reçu.

## Revendications

1. Capteur de motif thermique, tel qu'un capteur d'empreinte digitale, comportant plusieurs pixels (102) disposés sur un substrat (104), chaque pixel (102) comprenant une capacité pyroélectrique, la capacité pyroélectrique comprenant une couche en matériau pyroélectrique (200) poreux, disposée entre une première électrode électriquement conductrice (108) et une seconde électrode électriquement conductrice (110),
**caractérisé en ce que** des particules (210) en un premier matériau remplissent au moins partiellement les pores de la couche en matériau pyroélectrique (200) poreux,
le premier matériau étant électriquement isolant et ayant des propriétés pyroélectriques, et **caractérisé en ce que** qu'une couche (220) en un second matériau est disposée entre la couche en matériau pyroélectrique (200) et la seconde électrode (110),
le second matériau étant électriquement isolant et ayant des propriétés pyroélectriques.

2. Capteur selon la revendication 1, caractérisé ce que le premier matériau et/ou le second matériau sont en ZnO stoechiométrique.

3. Capteur selon la revendication 1, caractérisé ce que le premier matériau et/ou le second matériau sont en un mélange de Zn(OH)₂ et de ZnO, stoechiométrique et/ou non stoechiométrique.

4. Capteur selon la revendication 1, caractérisé ce que le premier matériau et/ou le second matériau sont en AIN.

5. Capteur selon la revendication 1, caractérisé ce que le premier matériau et/ou le second matériau sont en un mélange de AIN et de Zn(OH)₂ et/ou de ZnO stoechiométrique et/ou non stoechiométrique.

6. Capteur selon la revendication précédente, **caractérisé en ce que** le premier matériau et/ou le second matériau sont en un mélange de AIN et de ZnO/Zn(OH)₂ comprenant 50% massique de AIN.

7. Capteur selon l'une des revendications précédentes, **caractérisé en ce que** la couche (220) en un second matériau a une épaisseur allant de 10nm à 500nm, par exemple de 10nm à 300nm, et de préférence de 50nm à 500nm.

8. Capteur selon l'une quelconque des revendications précédentes, **caractérisé en ce que** le matériau pyroélectrique a une porosité supérieure à 15% de la surface totale du matériau pyroélectrique.

9. Procédé de fabrication d'un capteur de motif thermique, tel que défini dans l'une quelconque des revendications 1 à 8, comprenant les étapes successive suivantes :
a) fourniture d'un substrat (104), recouvert par une première électrode (108), et une couche en matériau pyroélectrique (200) poreux,
b) dépôt de particules (210) en un premier matériau, électriquement isolant et ayant des propriétés pyroélectriques, sur la couche en matériau pyroélectrique (200) poreux de manière à remplir au moins partiellement les pores de ladite couche (200),
c) dépôt d'une couche (220) en un second matériau sur la couche en matériau pyroélectrique (200), le second matériau étant en un matériau électriquement isolant et ayant des propriétés pyroélectriques, le second matériau étant de préférence identique au premier matériau.
d) formation d'une seconde électrode (110),
e) éventuellement dépôt d'une couche diélectrique (112) et formation d'un élément chauffant (114),
f) éventuellement, dépôt d'une couche de protection (116),

10. Procédé selon la revendication précédente, **caractérisé en ce que**, entre l'étape b) et l'étape d), et/ou éventuellement entre l'étape c) et l'étape d), le procédé comporte une étape additionnelle dans laquelle un traitement thermique à une température allant de 120°C à 180°C est réalisé.

11. Procédé selon l'une des revendications 9 et 10, **caractérisé en ce que** l'étape b) est réalisée en déposant une solution contenant des particules (210) en ZnO et/ou en un mélange de ZnO, stoechiométrique et/ou non stoechiométrique, et de Zn(OH)₂ et un solvant, de préférence choisi parmi l'acétate de butyle, l'acétate de propyle, l'isopropanol, l'éthanol, le méthanol, le méthoxyéthanol, l'éthoxyéthanol, l'hexane, et le cyclohexane.

12. Procédé selon la revendication précédente, **caractérisé en ce que** la solution contenant les particules (210) est déposée par dépôt à la tournette.

13. Procédé selon l'une des revendications 11 et 12, **caractérisé en ce que** la solution contient de 5mg/mL à 100mg/mL, et de préférence de 10mg/mL à 50mg/mL de particules (210).

14. Procédé selon l'une quelconque des revendications 9 à 13, **caractérisé en ce que** les particules (210) sont obtenues en réalisant les étapes successives suivantes :
- préparation et mélange d'une solution comprenant de l'acétate de zinc, du KOH, et un solvant dans lequel le ZnO et/ou le ZnO/Zn(OH)₂ sont insolubles,
- chauffage de la solution à la température d'ébullition du solvant, sous reflux, l'acétate de zinc et le KOH réagissant pour former des particules de ZnO et/ou de ZnO/Zn(OH)₂,
- décantation de la solution obtenue à l'étape précédente,
- de préférence, ajout d'un surfactant pour disperser les particules.

15. Procédé selon l'une quelconque des revendications 9 à 14, **caractérisé en ce que** la couche en matériau pyroélectrique (200) poreux est déposée par une technique d'impression telle que la sérigraphie.
